# EUROPÄISCHE PATENTSCHRIFT

(11) **EP 2 948 574 B1**
(45) Veröffentlichungstag und Bekanntmachung des Hinweises auf die Patenterteilung: **21.09.2016**
(21) Anmeldenummer: 15709091.1
(22) Anmeldetag: 27.02.2015
(51) Int. Cl.: C23C 18/42, C23C 18/54, C23C 18/16, C23C 18/08, C23C 26/00, B05D 7/20

(54) **VERFAHREN ZUM AUSBILDEN EINER EDELMETALLBESCHICHTUNG AUF EINEM METALLISCHEN SUBSTRAT**
METHOD FOR FORMING A NOBLE METAL COATING ON A METALLIC SUBSTRATE
PROCÉDÉ DE FORMATION D'UN REVÊTEMENT DE MÉTAL NOBLE SUR UN SUBSTRAT MÉTALLIQUE

(30) Priorität: 28.02.2014 EP 14000722
(43) Veröffentlichungstag der Anmeldung: 02.12.2015
(73) Patentinhaber: Aumann GmbH, 32339 Espelkamp (DE)
(72) Erfinder: NEDDERMANN, Horst, 32369 Rahden (DE)
(74) Vertreter: Thielking & Elbertzhagen Patentanwälte Partnerschaft mbB
(86) Internationale Anmeldenummer: PCT/EP2015/000459
(87) Internationale Veröffentlichungsnummer: WO 2015/128093

(56) Entgegenhaltungen:
- EP-A1- 1 887 106
- WO-A1-2013/020977
- WO-A1-2013/076548
- DE-A1- 3 741 328
- /: "Cu/Ag Silver Plated Copper Wire Silver Plated Copper Wire General Description", www.elektrisola.com, 1. Oktober 2009 (2009-10-01), XP055190901, Gefunden im Internet: URL:http://www.elektrisola.com/fileadmin/w ebdata/english/Downloads/ELEKTRISOLA_Datas heet_Cu-Ag.pdf [gefunden am 2015-05-21]

## Beschreibung

### TECHNISCHES GEBIET

Die Erfindung betrifft ein Verfahren zum Ausbilden einer Edelmetallbeschichtung auf wenigstens einem Bereich eines metallischen Substrats, insbesondere eines metallischen Drahtes, mit den Merkmalen von Patentanspruch 1.

### STAND DER TECHNIK

Es ist bekannt, dass Metalle in Abhängigkeit ihrer jeweiligen Reaktionsfreudigkeit und den sie umgebenden Bedingungen zur Oxidation neigen. Neben der Verwendung entsprechend edler Metalle oder geeigneter Legierungen werden diese daher oftmals mit einer Beschichtung versehen.

Insbesondere aufgrund ihrer elektrischen Leitfähigkeit in der Mikroelektronik in Form von Bonddraht eingesetzte Metalle müssen dabei weite Anforderungen erfüllen. So findet Bonddraht beispielsweise bei der Fertigung von Mikrochips Verwendung. Hier dient er der Verkettung des darin integrierten Schaltkreises oder beispielsweise eines Halbleiterbauelementes mit dem Gehäuse des Mikrochips. Auf diese Weise wird eine elektrisch leitfähige Verbindung zwischen den äußeren Anschlüssen des Mikrochips und dessen Innenleben realisiert.

Dabei wird ein möglichst geringer Querschnitt des Bonddrahtes angestrebt, um die notwendigen Verbindungen auf möglichst engem Raum überhaupt realisieren zu können. Um deren Bruch bei der zumeist mit Hochgeschwindigkeit erfolgenden Anordnung zu vermeiden, dürfen die für den Bonddraht verwendeten Materialien gleichzeitig keine spröden oder steifen Eigenschaften besitzen.

Wurden Bonddrähte bevorzugt aus Gold gebildet, werden diese aufgrund der steigenden Werkstoffkosten nun vermehrt aus kostengünstigeren Materialien wie etwa Kupfer, Aluminium, Silber oder anderen elektrisch leitenden Metallen erzeugt. Hinzu kommt, dass Bonddrähte aus Gold oder Silber eine bis zu 50% geringere mechanische Festigkeit gegenüber solchen aus kostengünstigeren Materialien besitzen können. Insbesondere die geringe mechanische Festigkeit von Bonddrähten aus Gold oder Silber kann bei deren späterer Verarbeitung zu Problemen führen. So lassen derartige Bonddrähte nur geringe Verarbeitungsgeschwindigkeiten zu.

Hinzu kommt, dass Bonddrähte aus Gold oder Silber auch hier im Kontakt mit Sauerstoff zur Oxidation neigen, was letztlich zu unerwünschten Leitungseinbußen bis hin zu Kontaktproblemen führen kann. Um dies zu verhindern, ist daher das Aufbringen einer geeigneten Beschichtung erforderlich. Hierzu kann auf einem metallischen Substrat - beispielsweise in Form eines Kerndrahtes - durch unterschiedliche Verfahren eine schützende Beschichtung ausgebildet werden.

So ist aus der WO 2013/076548 A1 ein Verfahren zur Herstellung von Bonddraht bekannt. Hierzu wird die Verwendung eines Kerndrahtes aus Silber oder einer Silberlegierung vorgeschlagen, welcher mit wenigstens einem der Materialien Gold, Palladium, Platin oder Rhodium beschichtet wird. Alternativ hierzu wird ein Kerndraht aus Kupfer oder einer Kupferlegierung verwendet, welcher mit einem der Materialien Palladium, Platin, Rhodium, Iridium oder Ruthenium beschichtet wird.

Ferner wird dort vorgeschlagen, den Kerndraht mit einem Material zu beschichten, dessen Schmelztemperatur über und dessen Siedetemperatur unter der des Kerndrahtes liegt. Weiterhin soll die Oberflächenspannung des geschmolzenen Materials zur Beschichtung über der des Kerndrahtes liegen. Die so geschaffene Beschichtung weist eine hohe Widerstandsfähigkeit gegenüber einer Oxidbildung in einem Temperaturbereich zwischen der Schmelztemperatur des Kerndrahtes und des Materials zur Beschichtung auf.

Für die Durchführung der Beschichtung des Kerndrahtes werden zudem verschiedene Beschichtungsverfahren angegeben. Die Beschichtung kann demnach mittels Elektroplattieren (galvanisch) oder stromlos erfolgen sowie durch Tauchplattieren, Dampfabscheidung, Kathodenzerstäubung (Sputtern), metallorganische Auflösung, Metallsalz Auflösung, Metall-Ligand-Auflösung, thermisches Spritzen, Konversionsbeschichten, thermische Zersetzung, Pyrolyse, Thermolyse, Ultraviolettbestrahlung und Auflösung sowie Sintern von Nanopartikeln. Anschließend erfolgt eine thermische Nachbehandlung des so beschichteten Kerndrahtes unter Schutzatmosphäre in einem Temperaturbereich von 200°C bis 600°C.

Gleichwohl weist auch die Verwendung eines Kerndrahtes aus Silber, einer Silberlegierung oder anderen elektrisch gut leitenden Edelmetallen hohe Werkstoffkosten auf. Zwar ist durch den Einsatz von Kupfer oder einer Kupferlegierung für den Kerndraht bereits eine deutliche Kostenreduzierung erzielbar, allerdings weisen die zu deren Beschichtung bekannten Verfahren und Materialien zum Teil noch Nachteile in Bezug auf deren Beständigkeit gegenüber einer Oxidation auf.

Im Stand der Technik ist ferner auch die Ausbildung einer Silberbeschichtung auf metallischen Substraten bekannt. Hierbei werden im Zuge eines galvanischen Prozesses einzelne Festkörperteile an Silber (Ag) auf dem metallischen Substrat abgelagert.

Derartige galvanische Verfahren sind insbesondere im Zusammenhang mit endlos herzustellenden Drahterzeugnissen als aufwendig und langwierig anzusehen. Zudem vermag beispielsweise die auf diese Art ausgebildete Silberbeschichtung in Bezug auf deren Beständigkeit gegenüber einer Oxidation nicht zu überzeugen.

### DIE ERFINDUNG

Vor diesem Hintergrund liegt der vorliegenden Erfindung die Aufgabe zugrunde, ein Verfahren zur Ausbildung einer Edelmetallbeschichtung, vorzugsweise einer Silberbeschichtung auf einem metallischen Substrat dahingehend zu verbessern, dass das so realisierte Drahterzeugnis eine hohe Beständigkeit gegenüber einer Oxidbildung aufweist.

Diese Aufgabe wird durch ein Verfahren mit den Merkmalen von Patentanspruch 1 gelöst.

Jeweils vorteilhafte Weiterbildungen des grundsätzlichen Erfindungsgedankens sind Gegenstand der jeweils abhängigen Patentansprüche.

Hiernach wird zunächst ein Verfahren zum Ausbilden einer Edelmetallbeschichtung auf wenigstens einem Bereich eines metallischen Substrats vorgeschlagen. Bei der Edelmetallbeschichtung kann es sich bevorzugt um eine Silberbeschichtung, Kupferbeschichtung, Palladiumbeschichtung, Goldbeschichtung oder Nickelbeschichtung handeln. Bei dem metallischen Substrat kann es sich insbesondere um einen metallischen Draht oder um ein strangförmiges Gut handeln. Das erfindungsgemäße Verfahren beinhaltet dabei folgende Schritte:
- Vorglühen des zu beschichteten Bereichs des Substrats,
- insbesondere kontaktloses oder kontaktbehaftetes, Aufbringen einer Edelmetalllösung auf den vorgeglühten Bereich des Substrats, wobei es sich bei der Edelmetalllösung bevorzugt um eine Silberlösung handeln kann,
- Einbrennen der auf das Substrat aufgebrachten Edelmetalllösung, vorzugsweise der Silberlösung,
- Abkühlen des mit der eingebrannten Edelmetalllösung, vorzugsweise der Silberlösung beschichteten Substrats.

Kontaktloses Aufbringen bedeutet, dass keine Auftragsvorrichtung mit dem Draht bzw. strangförmigen Gut in Kontakt gebracht wird, z. B. durch einen Sprühvorgang. Kontaktbehaftet bedeutet, dass ein Kontakt zwischen der Auftragsvorrichtung und dem strangförmigen Gut bzw. Draht erfolgt. "Aufbringen" wird im Rahmen dieser Offenbarung als Oberbegriff verstanden, der auch das Auftragen oder Abscheiden von Beschichtungsmaterial umfasst.

Das Einbrennen dient im Wesentlichen zur Trocknung der Edelmetalllösung auf dem Substrat. Trocknung bedeutet hier, dass jedenfalls Flüssigbestandteile verdampft werden, so dass im Wesentlichen nur das Edelmetall übrig bleibt. Diese Trocknung erfolgt bei Temperaturen von bevorzugt nicht mehr als 300 bis 500°C und richten sich nach der Verdampfungstemperatur der in der Edelmetalllösung enthaltenen Stoffe und der spezifischen Wärmekapazität des Substrates. Kann dieses beispielsweise die Wärme gut leiten und speichern, so reichen geringere Trocknungstemperaturen aus. Die Trocknung wird erfindungsgemäß in einem Temperaturbereich durchgeführt, der deutlich unterhalb des Temperaturbereichs liegt, der zum Aushärten, Sintern, des nach dem Trocknen auf dem Substrat verbliebenen Edelmetalls erforderlich ist. Typischerweise liegen die Temperaturen in dem Einbrenn- bzw. Trocknungsschritt mindestens 80 bis 170°, bevorzugt 100 bis 150°C unterhalb der Temperatur, die für das thermische Nachbehandeln im Anschluss an das vorzugsweise aktive, also prozessgesteuerte, Abkühlen erforderlich sind.

Nach dem Abkühlen wird das mit der eingebrannten Edelmetalllösung, vorzugsweise einer Silberlösung, Goldlösung, Kupferlösung, Palladiumlösung oder Nickellösung, beschichtete Substrat nach seiner Abkühlung zur thermischen Nachbehandlung nochmals erhitzt. Typischerweise wird für das Erhitzen zur Nachbehandlung eine Temperatur von 400 bis 600°C verwendet, abhängig von der Wahl der Temperatur im Einbrennschritt.

Der besondere Vorteil des erfindungsgemäßen Verfahrens liegt zunächst in der Verwendung einer Edelmetalllösung. Besonders bevorzugt wird im Rahmen der Erfindung als Edelmetalllösung eine Silberlösung verwendet. Diese kann in einfacher Art und Weise quasi kontinuierlich auf Oberflächenbereiche des metallischen Substrats aufgebracht werden, bevor dieses die weiteren Verfahrensschritte Einbrennen, Abkühlen, bevorzugt bis auf Raumtemperatur, insbesondere 20 bis 25°C, und das abschließende Nachbehandeln durch Erhitzen durchläuft. Das Abkühlen auf Raumtemperatur ist besonders vorteilhaft, da damit sichergestellt wird, dass die mit Edelmetall beschichtete Oberfläche nicht beschädigt wird, wenn der Draht bzw. das strangförmige Gut im weiteren Verlauf durch die Beschichtungsvorrichtung und insbesondere über Umlenkrollen geführt wird. Der Nachbehandlungsschritt durch Erhitzen ist zwingend erforderlich, denn würde die Edelmetalllösung bereits im Einbrennschritt vollständig eingebrannt, so würde das Edelmetall stark in das Substrat eindringen. Dadurch könnte aber der gewünschte geschlossene Edelmetallfilm nicht hergestellt werden. Tests haben gezeigt, dass eine nicht geschlossene Edelmetalloberfläche entsteht.

Das Substrat, insbesondere wenn es sich um Kupfer handelt, tendiert beim Einbrennen auch bei hohen Temperaturen stark zu oxidieren, was durch das Vorsehen einer Schutzgasatmosphäre beim Einbrennen und/oder Nachbehandeln reduziert wird.

Gegenüber galvanischen Verfahren ergibt sich hieraus die Möglichkeit einer mit nur wenig Aufwand einhergehenden Ausbildung einer Edelmetallbeschichtung auf einem metallischen Substrat. Vorzugsweise wird auf diese Weise eine Silberbeschichtung ausgebildet.

Durch den möglichen Endlosbetrieb ist die Ausbildung der Edelmetallbeschichtung, vorzugsweise in Form einer Silberbeschichtung zudem in kürzester Zeit realisierbar, was die Produktionskosten für derartige Erzeugnisse insgesamt deutlich reduziert.

Durch den Wegfall etwaiger zu beheizender Bäder zugunsten einer Vorglühvorrichtung und einer Einbrennvorrichtung sowie einer Kühlvorrichtung und einer zur thermischen Nachbehandlung dienenden Nachbrennvorrichtung ergeben sich zudem deutliche energetische Vorteile. Dies insbesondere vor dem Hintergrund, dass galvanische Bäder aufgrund ihrer zu beheizenden Masse eine kontinuierliche Erwärmung erfordern. Ein zwischenzeitliches Abschalten der Wärmezufuhr verlangt hier längere Standzeiten, bis diese wieder auf Betriebstemperatur gebracht werden können. Die demgegenüber als klein auszubildenden Vorrichtungen im Sinne des Erfindungsgedankens zum Erhitzen und Kühlen können dabei problemlos zwischenzeitlich ausgeschaltet werden, da diese innerhalb kürzester Zeit wieder auf Betriebstemperatur zu bringen sind.

In Bezug auf die Herstellung von so beschichteten Drahterzeugnissen können die zur Umsetzung der Erfindung erforderlichen Vorrichtungen zudem überaus kleine Abmessungen aufweisen. Hier kann das metallische Substrat in Form eines Drahtes oder strangförmigen Gutes im Endlosbetrieb durch die einzelnen Vorrichtungen transportiert werden, welche hierfür in einer Transportrichtung entsprechend hintereinander angeordnet sein können. Auf diese Weise muss der Draht keine möglichen Umlenkungen oder gar dessen Zusammenrollen mit kleinen Radien erleiden.

In einer bevorzugten Weiterbildung der erfindungsgemäßen Maßnahmen ist vorgesehen, dass das Vorglühen des metallischen Substrats bei einer Temperatur von 350°C bis 400°C durchgeführt werden kann. Das Vorglühen des Substrats dient hierbei primär dem Entfernen etwaiger unerwünschter Ablagerungen auf der Oberfläche des Substrats. Hierbei kann es sich beispielsweise um Öle, Fette und/oder Schmiermittel handeln. Diese werden aufgrund des angedachten Temperaturbereiches herunter geglüht und/oder verbrannt. Überdies wird das metallische Substrat durch dessen Erwärmung entsprechend weich gebracht. Auf diese Weise kann dessen Oberfläche für den anschließenden Auftrag der Silberlösung vorbereitet werden. Zudem wird das Material des Substrats durch die Wärmezufuhr entsprechend weicher, was beispielsweise dessen notwendige mechanische Umlenkung erleichtert.

Gemäß einer vorteilhaften Weiterbildung kann das Einbrennen der zuvor auf wenigstens einen Bereich des Substrats aufgetragenen Edelmetalllösung, bei der es sich vorzugsweise um eine Silberlösung handeln kann, bei einer Temperatur von 500°C bis 600°C durchgeführt werden. Dieser Temperaturbereich hat sich im Rahmen von Versuchen als ideal herausgestellt, um die in der Edelmetalllösung, vorzugsweise die in der Silberlösung enthaltenen Lösungsmittel herauszulösen.

Das Einbrennen der Edelmetalllösung erfolgt bevorzugt bei einer Temperatur unterhalb der Nachbehandlungstemperatur. Bevorzugt ist dabei, dass die Temperatur für das Einbrennen etwa zwischen 80 und 170°C, bevorzugt zwischen 100 und 150°C, geringer ist als die Nachbehandlungstemperatur. Auf diese Weise wird sichergestellt, dass die Edelmetallbeschichtung homogen auf dem Substrat verteilt wird und insbesondere keine vollständig ausgehärtete Beschichtung bereits beim Eintrocknen der Edelmetallbeschichtung entsteht. Nach einer besonders bevorzugte Maßnahme des erfindungsgemäßen Verfahrens ist vorgesehen, dass das Aufbringen der Edelmetalllösung, vorzugsweise der Silberlösung auf einen Oberflächenbereich des metallischen Substrats durch dessen Kontakt mit einem Auftragsmittel erfolgen kann.

Unter einem solchen Kontakt wird im Rahmen der Erfindung eine mechanische Berührung eines Bereiches des Substrats mit dem Auftragsmittel verstanden. Ein derartiger Kontakt kann beispielsweise durch eine beständige oder eine temporäre Berührung erfolgen. Besonders bevorzugt wird hierfür ein beständiger Kontakt durchgeführt, während diesem das Auftragsmittel und das Substrat relativ zueinander bewegt werden. In vorteilhafter Weise kann das Auftragsmittel hierzu örtlich fixiert sein, während das Substrat bei gleichzeitiger Berührung des Auftragsmittels an diesem vorbei bewegt wird.

Im Zusammenhang mit der Herstellung von so beschichteten Drahterzeugnissen oder strangförmigen Gütern kann das jeweilige Substrat dabei kontinuierlich an dem Auftragsmittel vorbeigezogen oder durch dieses hindurch gezogen werden. Im Ergebnis erfolgt durch den Kontakt zwischen Auftragsmittel und Substrat ein bevorzugt kontinuierliches Ablegen der Edelmetalllösung, vorzugsweise der Silberlösung auf einem Oberflächenbereich des Substrats.

Das Auftragsmittel kann hierfür beispielsweise einen elastischen Körper aufweisen. Dieser kann entweder fest angebracht oder beispielsweise in Form einer Walze rotierbar angeordnet sein. Der elastische Körper muss dabei eine zumindest temporäre Speicherfähigkeit für die Edelmetalllösung, bei der es sich vorzugsweise um eine Silberlösung handeln kann, aufweisen, so dass diese störungsfrei auf dem Substrat abgelegt werden kann. Auf diese Weise wird das Auftragsmittel entweder kontinuierlich oder in Zeitabständen mit der Edelmetalllösung, vorzugsweise mit der Silberlösung getränkt.

Bevorzugt ist das Auftragsmittel mit einer geeigneten Zufuhreinheit fluidleitend verbunden. Bei der Zufuhreinheit kann es sich beispielsweise um einen Dosierer handeln, welcher entweder kontinuierlich eine gleichbleibende Menge oder aber in zeitlichen Abständen eine festgelegte Menge der Edelmetalllösung, vorzugsweise der Silberlösung an das Auftragsmittel weiterleitet.

Selbstverständlich kann das mechanische Auftragsmittel auch durch eine Auftragsanordnung ersetzt oder ergänzt werden, welche ein kontaktloses Aufbringen der Edelmetalllösung, vorzugsweise der Silberlösung auf das Substrat ermöglicht. Denkbar hierbei wäre beispielsweise der Einsatz einer Sprühanordnung, welche mittels Luftdruck oder aber reinem Materialdruck (Airless) eine entsprechende Beschleunigung der Edelmetalllösung, vorzugsweise der Silberlösung ermöglicht, welche dann gerichtet auf dem Substrat abgelegt wird.

Nach einer besonders vorteilhaften Weiterbildung der Erfindung ist vorgesehen, dass das bereits mit der eingebrannten Edelmetalllösung, vorzugsweise mit der Silberlösung beschichtete Substrat nach seiner Abkühlung erneut auf eine Nachbehandlungstemperatur erhitzt wird, welche in einem Temperaturbereich von 400°C bis 600°C liegt. Im Rahmen der so stattfindenden thermischen Nachbehandlung des bereits mit der Edelmetalllösung, vorzugsweise mit der Silberbeschichtung beschichteten Substrats wird deren Beständigkeit gegenüber einer Oxidation auf ein Maximum erhöht.

Spätestens im Zuge der thermischen Nachbehandlung wird eine intermetallische Phase zwischen der Edelmetallbeschichtung, vorzugsweise mit der Silberbeschichtung und dem metallischen Substrat realisiert, aufgrund derer eine hohe Widerstandsfähigkeit vor einer Oxidierung erreicht wird.

Die Erfindung sieht ferner vor, dass bereits das Vorglühen des Substrats unter Verwendung einer Schutzatmosphäre erfolgen kann. So kann das Vorglühen bevorzugt unter der Verwendung eines Schutzgases durchgeführt werden. In Kombination oder alternativ hierzu kann auch das Erhitzen des bereits beschichteten Substrats im Zusammenhang mit dessen thermischer Nachbehandlung unter Verwendung eines Schutzgases erfolgen. Aufgrund des durch das Schutzgas reduzierten oder gar nicht vorhandenen Anteils an Luftsauerstoff wird insbesondere der bei ansteigenden Temperaturen erhöhten Reaktionsfreudigkeit der verwendeten Metalle mit Sauerstoff entgegengewirkt.

Gemäß einer besonders bevorzugten Weiterbildung des grundsätzlichen Erfindungsgedankens ist vorgesehen, dass die im Rahmen des erfindungsgemäßen Verfahrens verwendete und somit aufzubringende Edelmetalllösung, bei welcher es sich vorzugsweise um eine Silberlösung, Goldlösung Kupferlösung, Nickellösung oder Palladiumlösung handelt, folgende Anteile in Gew.-% umfasst:
- Ethanol 50 - 65,
- Edelmetallverbindung, insbesondere Silberverbindung, Goldverbindung, Nickelverbindung, Palladiumverbindung oder Kupferverbindung, 30 - 45,
- Organische Amine > 0 und < 10,
- Stabilisatoren 5 - 10.

Darüber hinaus kann die Edelmetalllösung, vorzugsweise die Silberlösung, Goldlösung, Kupferlösung, Nickellösung oder Palladiumlösung, einen unvermeidlichen Rest an produktionsbedingten Verunreinigungen umfassen. Dabei sind die organischen Amine in einer mit einem Anteil von größer 0,0 Gew.-% und kleiner als 10 Gew.-% in der Edelmetalllösung enthalten. Weiter weist die Edelmetallverbindung in Form der bevorzugten Silberverbindung, Goldverbindung, Kupferverbindung, Nickelverbindung oder Palladiumverbindung einen Festkörperanteil an Silber (Ag), Gold (Au), Kupfer (Cu), Nickel (Ni) bzw. Palladium (Pd) von größer (>) 0,0% Gew. bis einschließlich 40,0% Gew. auf.

Die zuvor angegebenen Inhalte der Edelmetalllösung haben sich im Rahmen von Versuchen im Zusammenhang mit den zuvor beschriebenen Maßnahmen als besonders vorteilhaft herausgestellt. Im Ergebnis konnte so eine gegenüber einer Oxidation überaus beständige Edelmetallbeschichtung insbesondere in Form der bevorzugten Silberbeschichtung ausgebildet werden.

Dank des zuvor aufgezeigten erfindungsgemäßen Verfahrens ist es nunmehr möglich, eine gegenüber Oxidation beständige und mit nur wenig Aufwand realisierbare Edelmetallbeschichtung, bei welcher es sich bevorzugt um eine Silberbeschichtung handelt, auf einem metallischen Substrat auszubilden. Insbesondere die Verwendung des aufzubringenden Edelmetalls, beispielsweise des bevorzugten Silbers (Ag) in Form der Edelmetalllösung bzw. der bevorzugten Silberlösung bietet gegenüber galvanischen Verfahren den Vorteil einer schnellen und überaus kostengünstigen Produktion entsprechender Erzeugnisse.

Die Erfindung sieht in vorteilhafter Weise vor, dass der Auftrag der Beschichtung in mehreren Stufen zeitgleich erfolgen kann. Auf diese Weise können Produktionsgeschwindigkeiten von bis zu 25 Meter pro Sekunde (m/s) erreicht werden.

Nachfolgend wird eine Beschichtungsanordnung beschrieben, welche sich zur Ausbildung einer Edelmetallbeschichtung, vorzugsweise einer Silberbeschichtung auf einem metallischen Substrat, insbesondere im Rahmen des zuvor aufgezeigten Verfahrens, eignet.

Die Beschichtungsanordnung umfasst dabei eine Vorglühvorrichtung, eine Auftragsvorrichtung, eine Einbrennvorrichtung sowie eine Kühlvorrichtung und eine Nachbrennvorrichtung. Hierbei sieht die Erfindung vor, dass die zuvor aufgeführten Vorrichtungen in einer Transportrichtung der Beschichtungsanordnung hintereinander angeordnet sind. Dabei ist die Auftragsvorrichtung dazu ausgebildet, um eine Edelmetalllösung auf den zu beschichtenden Bereich des mittels der Vorglühvorrichtung zuvor vorgeglühten Substrats aufzutragen. Bei der Edelmetalllösung kann es sich bevorzugt um eine Silberlösung handeln. Weiterhin ist die Nachbrennvorrichtung dazu ausgebildet, um das mit der eingebrannten Edelmetalllösung, vorzugsweise mit der Silberlösung beschichtete und durch die Kühlvorrichtung abgekühlte Substrat im Rahmen einer thermischen Nachbehandlung nochmals zu erhitzen.

Die sich hieraus ergebenden Vorteile wurden bereits im Zusammenhang mit dem zuvor erläuterten erfindungsgemäßen Verfahren näher ausgeführt. Zur Vermeidung von Wiederholungen wird daher an dieser Stelle auf die vorherigen Ausführungen hierzu verwiesen. Überdies sind sämtliche vorherigen Ausführungen sowie Ausgestaltungen und Weiterentwicklungen der Erfindung auch auf die nachfolgend erläuterte Weiterbildung der Beschichtungsanordnung sowie das ebenfalls im weiteren Verlauf dargestellte und mit Hilfe des erfindungsgemäßen Verfahrens und/oder der erfindungsgemäßen Beschichtungsanordnung hergestellten erfindungsgemäße Drahterzeugnis anzuwenden, so dass sich hieraus ergebende Weiterentwicklungen sowie Ausgestaltungen auch für diese gelten und umgekehrt.

Hiernach ist in einer vorteilhaften Weiterentwicklung der Beschichtungsanordnung vorgesehen, dass die Einbrennvorrichtung einen Katalysator und einen Lüfter besitzt. Dabei ist der Lüfter dazu ausgebildet, einen gegen die Transportrichtung gerichteten Luftstrom innerhalb der Einbrennvorrichtung zu erzeugen. In diesem Zusammenhang sind der Lüfter und der Katalysator derart zueinander angeordnet, dass der durch den Lüfter erzeugte Luftstrom nach seiner Beaufschlagung des Substrats zu dem Katalysator hin leitbar ist.

Mit anderen Worten läuft das zu beschichtende Substrat hierbei gegen den Luftstrom in die Einbrennvorrichtung ein, wobei der Luftstrom das Substrat umspült. Bei diesem Umspülen können die aus der aufgetragenen Edelmetalllösung, bei welcher es sich bevorzugt um eine Silberlösung handeln kann, heraus diffundierenden Lösungsmittel durch den Luftstrom mitgenommen werden. Durch die so realisierte Strömungsrichtung des Luftstroms wird der Lösungsmittel enthaltende Luftstrom anschließend zu dem Katalysator geleitet, um diesen aus dem Luftstrom wieder zu lösen.

In Bezug auf das durch die Erfindung herstellbare Drahterzeugnis oder strangförmige Gut umfasst dieses ein metallisches Substrat, welches eine zumindest bereichsweise auf diesem ausgebildete Edelmetallbeschichtung besitzt. Bevorzugt handelt es sich bei der Edelmetallbeschichtung um eine Silberbeschichtung. Besonders bevorzugt wird das Drahterzeugnis oder das strangförmige Gut mit dem zuvor aufgezeigten Verfahren und/ oder der zuvor beschriebenen Beschichtungsanordnung hergestellt. Die auf dem Substrat ausgebildete Edelmetallbeschichtung, bei welcher es sich bevorzugt um eine Silberbeschichtung handeln kann, besitzt dabei eine hohe Beständigkeit gegenüber einer Oxidbildung.

Das erfindungsgemäß hergestellte Drahterzeugnis oder strangförmige Gut, welches insbesondere mit dem erfindungsgemäßen Verfahren hergestellt sein kann, weist gegenüber solchen mit einem Substrat (beispielsweise als Kerndraht) aus Gold oder Silber oder einer Silberlegierung vorteilhaftere mechanische Eigenschaften auf. Diese Vorteile machen sich insbesondere bei der späteren Verarbeitung des erfindungsgemäßen Drahterzeugnisses oder strangförmigen Gutes bemerkbar.

Zudem weist das erfindungsgemäß hergestellte Drahterzeugnis oder strangförmige Gut gegenüber solchen mit entsprechenden galvanischen Verfahren veredelten eine verbesserte Energiebilanz auf. Bei dem verwendeten Substrat kann es sich beispielsweise um Kupfer oder eine Kupferlegierung handeln.

Auch lässt das erfindungsgemäß hergestellte Drahterzeugnis oder strangförmige Gut gegenüber solchen mit entsprechenden galvanischen Verfahren veredelten höhere Produktionsgeschwindigkeiten zu, beispielsweise beim Drahtbonden.

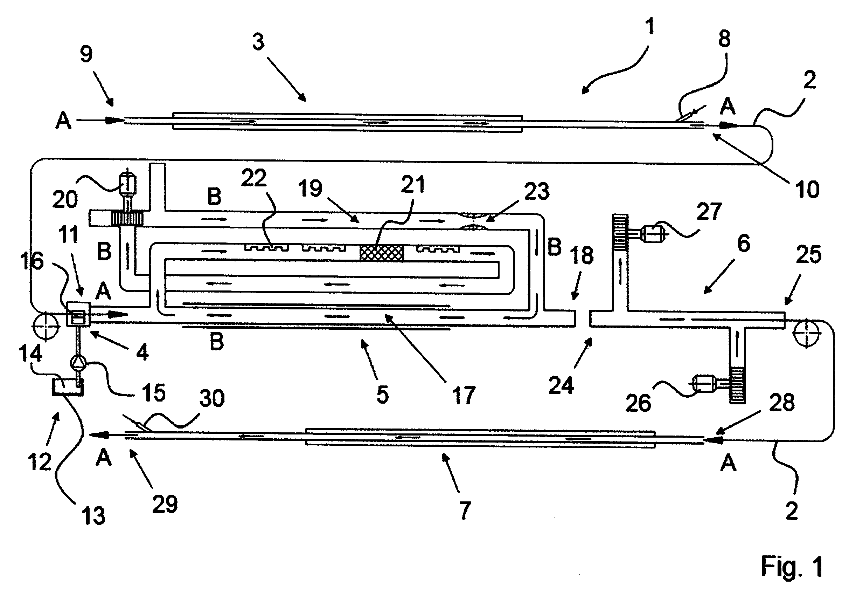

Weitere Ausgestaltungen des Verfahrens sowie der Beschichtungsanordnung sowie des Drahterzeugnisses können sich durch eine technisch sinnvolle Kombination einzelner oder mehrerer in der vorherigen Beschreibung aufgezeigter Merkmale sowie Maßnahmen ergeben und werden ausdrücklich im Rahmen der Erfindung mit beansprucht. Weitere Charakterisierungen und Spezifizierungen der Erfindung können sich insbesondere im Zusammenhang mit der nachfolgend beschriebenen Figur 1 ergeben, welche ebenfalls als Teil der Erfindung angesehen und beansprucht wird.

### KURZESCHREIBNG DER ZEICHNUNG

Figur 1 zeigt eine erfindungsgemäß geeignete Beschichtungsanordnung 1, welche sich beispielsweise zur Durchführung des erfindungsgemäßen Verfahrens zum Ausbilden einer Edelmetallbeschichtung, vorzugsweise einer Silberbeschichtung auf wenigstens einem Bereich eines metallischen Substrats 2 eignet.

### BESTER WEG ZUR AUSFÜHRUNG DER ERFINDUNG

Vorliegend handelt es sich bei dem .Substrat 2 um einen metallischen Draht, welcher die Beschichtungsanordnung 1 als quasi endloser Strang durchläuft.

Wie zu erkennen, durchläuft das zu beschichtende Substrat 2 die einzelnen Stationen der Beschichtungsanordnung 1 in einer Transportrichtung A. Die Beschichtungsanordnung 1 umfasst einzelne Vorrichtungen 3 - 7 in Form einer Vorglühvorrichtung 3, einer Auftragsvorrichtung 4, einer Einbrennvorrichtung 5 sowie einer Kühlvorrichtung 6 und einer Nachbrennvorrichtung 7.

Die Vorglühvorrichtung 3 besitzt einen Zugang 8, durch welchen ein Schutzgas zur Ausbildung einer Schutzatmosphäre in das Innere der Vorglühvorrichtung 3 geleitet werden kann. Weiterhin weist die Vorglühvorrichtung 3 eine Eingangsseite 9 sowie eine Ausgangsseite 10 auf, wobei das Substrat 2 durch die Eingangsseite 9 hindurch in das Innere der Vorglühvorrichtung 3 eintreten kann. Hierin wird das Substrat 2 im Schutz der Schutzatmosphäre in einem Temperaturbereich von bevorzugt 350°C bis 400°C vorgeglüht. Auf diese Weise werden zunächst etwaige auf der Oberfläche des Substrats 2 anhaftende Stoffe wie etwa Öle, Fette und/oder Schmierstoffe heruntergeglüht und/oder verbrannt. Gleichzeitig wird das Substrat 2 durch seine Erwärmung weicher.

Anschließend verlässt das so vorgeglühte Substrat 2 die Vorglühvorrichtung 3 durch deren Ausgangsseite 10 und gelangt anschließend zu jener, der Vorglühvorrichtung 3 nachgeschalteten Auftragsvorrichtung 4. Die Auftragsvorrichtung 4 ist dabei unmittelbar vor einer Eingangsseite 11 der Einbrennvorrichtung 5 angeordnet, so dass das Substrat 2 vor seinem Einlauf in die Einbrennvorrichtung 5 die Auftragsvorrichtung 4 passiert.

Die Auftragsvorrichtung 4 ist mit einer Zufuhreinheit 12 fluidleitend verbunden. Die Zufuhreinheit 12 kann als Dosierer ausgebildet sein. Vorliegend besitzt die Zufuhreinheit 12 ein Reservoir 13 für eine Edelmetalllösung 14, welche über eine Pumpe 15 kontinuierlich zu einem Auftragsmittel 16 als Teil der Auftragsvorrichtung 4 geleitet wird. Bei der Edelmetalllösung 14 kann es sich bevorzugt um eine Silberlösung handeln. Somit ist die Auftragsvorrichtung 4 dazu ausgebildet, die Edelmetalllösung 14, bevorzugt in Form einer Silberlösung über einen Kontakt des Auftragsmittels 16 zu dem Substrat 2 auf den bereits vorgeglühten Oberflächenbereich des Substrats 2 aufzubringen.

Nach dem Auftrag der Edelmetalllösung 14, bevorzugt in Form der Silberlösung, läuft der so präparierte Abschnitt des Substrats 2 anschließend durch die Eingangsseite 11 hindurch in die Einbrennvorrichtung 5 ein. Die Einbrennvorrichtung 5 weist einen Einbrenntunnel 17 auf, welcher eine der Eingangsseite 11 gegenüberliegende Ausgangsseite 18 besitzt. Zwischen der Eingangsseite 11 und der Ausgangsseite 18 des Einbrenntunnels 17 ist ein Strömungskreislauf 19 fluidleitend mit dem Einbrenntunnel 17 verbunden. Weiterhin weist die Einbrennvorrichtung 5 einen Lüfter 20 und einen Katalysator 21 sowie wenigstens eine Heizeinrichtung 22 auf, welche allesamt in dem Strömungskreislauf 19 angeordnet sind.

Der Lüfter 20 ist dazu ausgebildet, um einen gegen die Transportrichtung A gerichteten Luftstrom B innerhalb der Einbrennvorrichtung 5 zu erzeugen. Der Luftstrom B zirkuliert dabei durch den Einbrenntunnel 17 und den Strömungskreislauf 19 der Einbrennvorrichtung 5. Dabei sind der Lüfter 20 und der Katalysator 21 derart zueinander angeordnet, dass der Luftstrom B nach seiner Beaufschlagung des Substrats 2 zu dem Katalysator 21 hin leitbar ist. Vorliegend ist der Katalysator 21 stromabwärts des Lüfters 20 in Bezug auf die Richtung des Luftstroms B angeordnet. Während der Zirkulation des Luftstroms B wird dieser über die Heizeinrichtung 22 erhitzt. Der angestrebte Temperaturbereich des das Substrat 2 beaufschlagenden Luftstroms B reicht bevorzugt von 500°C bis 600°C. Dabei dient der Katalysator 21 dem Entfernen von nicht näher gezeigten Lösungsmitteln, welche aus der aufgebrachten Edelmetalllösung 14, bevorzugt in Form der Silberlösung innerhalb der Einbrennvorrichtung 5 heraus diffundieren.

Um eine Beschleunigung und/oder Druckerhöhung des Luftstroms B im Inneren des Einbrenntunnels 17 zu erzielen, weist der Strömungskreislauf 19 kurz vor Erreichen des Einbrenntunnels 17 entsprechende Einbauten 23 auf. Bei den Einbauten 23 handelt es sich bevorzugt um wenigstens eine den Querschnitt des Strömungskreislaufs 19 verengende Drossel.

Nachdem das mit der nunmehr eingebrannten Edelmetalllösung 14, bevorzugt mit der eingebrannten Silberlösung beschichtete Substrat 2 die Einbrennvorrichtung 5 durch deren Ausgangsseite 18 verlassen hat, wird es anschließend der Kühlvorrichtung 6 zugeführt. Hierzu besitzt auch die Kühlvorrichtung 6 eine entsprechende Eingangsseite 24 und eine Ausgangsseite 25, so dass das Substrat 2 durch die Kühlvorrichtung 6 in Transportrichtung A hindurchgeleitet werden kann.

Die Kühlvorrichtung 6 umfasst zwei Lüfter 26, 27, von denen ein erster Lüfter 26 dem Einblasen von Kühlluft C in die Kühlvorrichtung 6 dient, während der entsprechend zweite Lüfter 27 für die Absaugung der Kühlluft C aus der Kühlvorrichtung 6 heraus vorgesehen ist. Insofern werden beide Lüfter 26, 27 parallel zueinander betrieben, wobei auf diese Weise ein gegen die Transportrichtung A verlaufender Strom an Kühlluft C erzeugt wird.

Sobald das somit abgekühlte Substrat 2 die Kühlvorrichtung 6 durch deren Ausgangsseite 25 verlassen hat, läuft es letztlich in die Nachbrennvorrichtung 7 ein. Die Nachbrennvorrichtung 7 dient der thermischen Nachbehandlung des bereits beschichteten Substrats 2. So weist die Nachbrennvorrichtung 7 eine Eingangsseite 28 und eine Ausgangsseite 29 auf, wobei das Substrat 2 durch die Eingangsseite 28 hindurch in die Nachbrennvorrichtung 7 eingeführt wird. Innerhalb der Nachbrennvorrichtung 7 wird das Substrat 2 erhitzt, wobei der bevorzugte Temperaturbereich von 400°C bis 600°C reicht. Im Bereich der Ausgangsseite 29 weist die Nachbrennvorrichtung 7 ferner einen Zugang 30 auf, durch welchen hindurch Schutzgas zur Ausbildung einer Schutzatmosphäre im Inneren der Nachbrennvorrichtung 7 eingeleitet werden kann.

Abschließend verlässt das so thermisch nachbehandelte Substrat 2 die Nachbrennvorrichtung 7 über deren Ausgangsseite 28.

## Patentansprüche

1. Verfahren zum Ausbilden einer Edelmetallbeschichtung, vorzugsweise einer Silberbeschichtung, Goldbeschichtung, Kupferbeschichtung, Nickelbeschichtung oder Palladiumbeschichtung, auf wenigstens einem Bereich eines metallischen Substrats (2) in Form eines metallischen Drahtes oder strangförmigen Gutes, mit folgenden Schritten:
- Vorglühen des zu beschichteten Bereichs des Substrats (2),
- Aufbringen einer Edelmetalllösung (14), vorzugsweise einer Silberlösung, Goldlösung, Kupferlösung, Nickellösung oder Palladiumlösung (14), auf den vorgeglühten Bereich des Substrats (2),
- Einbrennen der auf das Substrat (2) aufgebrachten Edelmetalllösung (14),
- Abkühlen des mit der eingebrannten Edelmetalllösung (14) beschichteten Substrats (2),
wobei das mit der eingebrannten Edelmetalllösung (14) beschichtete Substrat (2) nach seiner Abkühlung zu dessen thermischen Nachbehandlung nochmals erhitzt wird, **dadurch gekennzeichnet,**
**dass** das Einbrennen der Edelmetalllösung (14) bei einer Temperatur von 500°C bis 600°C durchgeführt wird.

2. Verfahren nach Anspruch 1,
**dadurch gekennzeichnet,**
**dass** das Vorglühen bei einer Temperatur von 350°C bis 400°C durchgeführt wird.

3. Verfahren nach einem der vorigen Ansprüche,
**dadurch gekennzeichnet,**
**dass** das Einbrennen der Edelmetalllösung (14) bei einer Temperatur unterhalb der Nachbehandlungstemperatur durchgeführt wird.

4. Verfahren nach Anspruch 3,
**dadurch gekennzeichnet,**
**dass** die Temperatur für das Einbrennen zwischen 80 und 170°C, bevorzugt zwischen 100 und 150°C, geringer ist als die Nachbehandlungstemperatur.

5. Verfahren nach einem der vorhergehenden Ansprüche,
**dadurch gekennzeichnet,**
**dass** das Aufbringen der Edelmetalllösung (14) durch einen Kontakt des Substrats (2) mit einem Auftragsmittel (16) erfolgt, wobei das Auftragsmittel (16) mit der Edelmetalllösung (14) getränkt wird.

6. Verfahren nach einem der vorhergehenden Ansprüche,
**dadurch gekennzeichnet,**
**dass** das Aufbringen der Edelmetalllösung (14) durch eine Auftragsanordnung, insbesondere Sprühanordnung, kontaktlos erfolgt.

7. Verfahren nach einem der vorhergehenden Ansprüche,
**dadurch gekennzeichnet,**
**dass** das Vorglühen des unbeschichteten Substrats (2) und/oder das zur thermischen Nachbehandlung des bereits beschichteten Substrats dienende Erhitzen des Substrats (2) unter Verwendung eines Schutzgases durchgeführt wird.

8. Verfahren nach einem der vorhergehenden Ansprüche,
**dadurch gekennzeichnet,**
**dass** die aufzubringende Edelmetalllösung (14) folgende Anteile in Gew.-% umfasst:
- Ethanol 50 - 65,
- Edelmetallverbindung, 30 - 45,
- Organische Amine > 0 und < 10,
- Stabilisatoren 5 - 10,
- Rest produktionsbedingte Verunreinigungen, wobei die Edelmetallverbindung einen Festkörperanteil an Edelmetall, vorzugsweise Silber (Ag), von größer (>) 0,0% Gew. bis einschließlich 40,0% Gew. aufweist.

## Claims

1. Method for forming a noble metal coating, preferably a silver coating, gold coating, copper coating, nickel coating or palladium coating, on at least one area of a metallic substrate (2) in the form of a metallic wire or string material, with the following steps:
- preheating the area of the substrate (2) which is to be coated,
- applying a noble metal solution (14), preferably a silver solution, gold solution, copper solution, nickel solution, or palladium solution (14), to the preheated area of the substrate (2)
- firing the noble metal solution (14) applied to the substrate (2)
- cooling the substrate (2) which has been coated with the fired noble metal solution
wherein the substrate (2) which has been coated with the fired noble metal solution (14) after it has cooled is heated again for its thermal after-treatment, **characterised in that**
the firing of the noble metal solution (14) is carried out in a temperature range from 500°C to 600°C.

2. Method according to claim 1
**characterised in that**
the preheating is carried out at a temperature of 350°C to 400°C.

3. Method according to one of the preceding claims
**characterised in that**
the firing of the noble metal solution (14) is carried out at a temperature below the after-treatment temperature.

4. Method according to claim 3
**characterised in that**
the temperature for firing is between 80 and 170°C, preferably between 100 and 150°C, lower than the after-treatment temperature.

5. Method according to one of the preceding claims
**characterised in that**
the application of the noble metal solution (14) takes place through contact of the substrate (2) with an application means (16) wherein the application means (16) is impregnated with the noble metal solution (14).

6. Method according to one of the preceding claims
**characterised in that**
the application of the noble metal solution (14) takes place contactlessly through an application arrangement, more particularly a spray arrangement.

7. Method according to one of the preceding claims
**characterised in that**
the preheating of the uncoated substrate (2) and/or the heating of the substrate (2) serving for the thermal after-treatment of the already coated substrate is carried out by using a protective gas.

8. Method according to one of the preceding claims
**characterised in that**
the noble metal solution (14) which is to be applied comprises the following proportions, in % by weight:
- ethanol 50 - 65
- noble metal compound 30 - 45
- organic amines > 0 and < 10
- stabilizers 5 - 10,
- remainder impurities as a result of production
wherein the noble metal compound has a solid body proportion of noble metal, preferably silver (Ag), of more than (>) 0.0 % b.w. up to and including 40 % b.w.

## Revendications

1. Procédé de formation d'un revêtement de métal noble, de préférence d'un revêtement d'argent, revêtement d'or, revêtement de cuivre, revêtement de nickel ou revêtement de palladium, sur au moins un secteur d'un substrat métallique (2) se présentant sous la forme d'un fil métallique ou d'un matériau en forme de faisceau, avec les étapes suivantes:
- préchauffage de la zone du substrat (2) devant être revêtue,
- application d'une solution de métal noble (14), de préférence d'une solution d'argent, solution d'or, solution de cuivre, solution de nickel ou solution de palladium (14), sur la zone du substrat (2) préalablement chauffée,
- cuisson de la solution de métal noble (14) appliquée sur le substrat (2),
- refroidissement du substrat (2) revêtu de la solution de métal noble (14) cuite,
sachant que le substrat (2), revêtu de la solution de métal noble (14) cuite, est chauffée de nouveau après son refroidissement pour son post-traitement thermique, **caractérisé en ce que**
la cuisson de la solution de métal noble (14) est exécutée à une température de 500°C à 600°C.

2. Procédé selon la revendication 1,
**caractérisé en ce que**
le préchauffage est exécuté à une température de 350°C à 400°C.

3. Procédé selon l'une des revendications précédentes,
**caractérisé en ce que**
la cuisson de la solution de métal noble (14) est exécutée à une température inférieure à la température de post-traitement.

4. Procédé selon la revendication 3,
**caractérisé en ce que**
la température de cuisson, située entre 80 et 170°C, de préférence entre 100 et 150°C, est inférieure à la température de post-traitement.

5. Procédé selon l'une des revendications précédentes,
**caractérisé en ce que**
l'application de la solution de métal noble (14) est effectuée par une mise en contact du substrat (2) avec un moyen d'application (16), sachant que le moyen d'application (16) est imbibé avec la solution de métal noble (14).

6. Procédé selon l'une des revendications précédentes,
**caractérisé en ce que**,
l'application de la solution de métal noble (14) est effectuée sans contact, par un ensemble d'application, en particulier par un ensemble de pulvérisation.

7. Procédé selon l'une des revendications précédentes,
**caractérisé en ce que**,
le préchauffage du substrat (2) non revêtu et / ou le chauffage du substrat (2), servant au post-traitement thermique du substrat déjà revêtu, sont effectués avec recours à un gaz de protection.

8. Procédé selon l'une des revendications précédentes,
**caractérisé en ce que**
la solution de métal noble (14) à appliquer présente les teneurs en % en poids suivantes:
- éthanol 50 - 65,
- composition de métal noble 30 - 45,
- amine organique > 0 et < 10,
- stabilisateurs 5 - 10,
- le reste consistant en impuretés résultant de la production, sachant que la composition de métal noble présente une teneur en corps solides de métal noble, de préférence d'argent (Ag), supérieure (>) à 0,0 % en poids jusqu'à y compris 40,0 % en poids.
